Europäisches Patentamt

European Patent Office

Office européen des brevets

(11) Publication number: 0 300 656
A2

## (12) EUROPEAN PATENT APPLICATION

(21) Application number: 88306281.2

(22) Date of filing: 08.07.88

(51) Int. Cl.4: H03H 11/26 , H03H 11/54

(30) Priority: 18.07.87 GB 8716985

(43) Date of publication of application:
25.01.89 Bulletin 89/04

(84) Designated Contracting States:
DE FR GB NL

(71) Applicant: THORN EMI plc
4 Tenterden Street
London W1R 9AH(GB)

(72) Inventor: Seymour, Colin Julian
60 Stuart Avenue
South Harrow Middlesex HA2 9AZ(GB)

(74) Representative: Marsh, Robin Geoffrey et al
Thorn EMI Patents Limited The Quadrangle
Westmount Centre Uxbridge Road
Hayes Middlesex, UB4 0HB(GB)

(54) Temperature compensated delay line.

(57) A device for compensating for variations in the delay times of an operational delay line comprising: a control delay line (5) to introduce a measurable phase shift into a signal passing along it; a variable frequency oscillator (1) to provide the control delay line (5) with said signal; a frequency independent reference signal having a predetermined phase shift to act as a reference for the control delay line signal, and means (11) for controlling the frequency of the variable frequency oscillator (1) so that the phase shift in the delay signal is maintained substantially constant and equal to the phase shift of the reference signal.

FIG.2

## TEMPERATURE COMPENSATED DELAY LINE

This invention relates to delay lines and, in particular to temperature compensation of delay lines.

In certain circumstances, the effects of temperature and ageing on the delay time of a delay line may result in associated circuitry being unable to sychronise with the delayed signal coming out of the delay line. Although these delay variations are small they become significant over a long delay time when wide bandwidths allow fast operation to be used, which is possible with surface acoustic wave (SAW) delay lines. This effect may then prevent a delayed pulse from being accurately gated out of a noisy background as for example in radar ECM.

It is therefore an object of the present invention to provide a device which can compensate for these effects.

According to the present invention there is provided a device for compensating for variations in the delay times of an operational delay line comprising:

a control delay line to introduce a measurable phase shift into a signal passing along it;

a variable frequency oscillator to provide the control delay line with said signal;

a frequency independent reference signal having a predetermined phase shift to act as a reference for the control delay line signal, and

means for controlling the frequency of the variable frequency oscillator so that the phase shift in the delay signal is maintained substantially constant and equal to the phase shift of the reference signal.

Preferably, the means for controlling the variable frequency oscillator comprises a phase locked loop.

Preferably, the means for controlling the variable frequency oscillator additionally comprises means for generating a carrier wave which is frequency modulated by the signal from the variable frequency oscillator in order to simulate the conditions of operation of a functional delay line.

The invention will be described by way of example only with reference to the accompaning drawings of which:-

Figure 1 shows a functional block diagram of a device according to one embodiment of the invention,

Figure 2 shows a functional block diagram of a device according to another embodiment of the invention,

Figure 3(a) shows a typical circuit for a phase comparator for use in the invention,

Figure 3(b) is a timing diagram of the signals generated by the phase comparator of Figure 3(a).

Figure 4 shows an example of the invention in use.

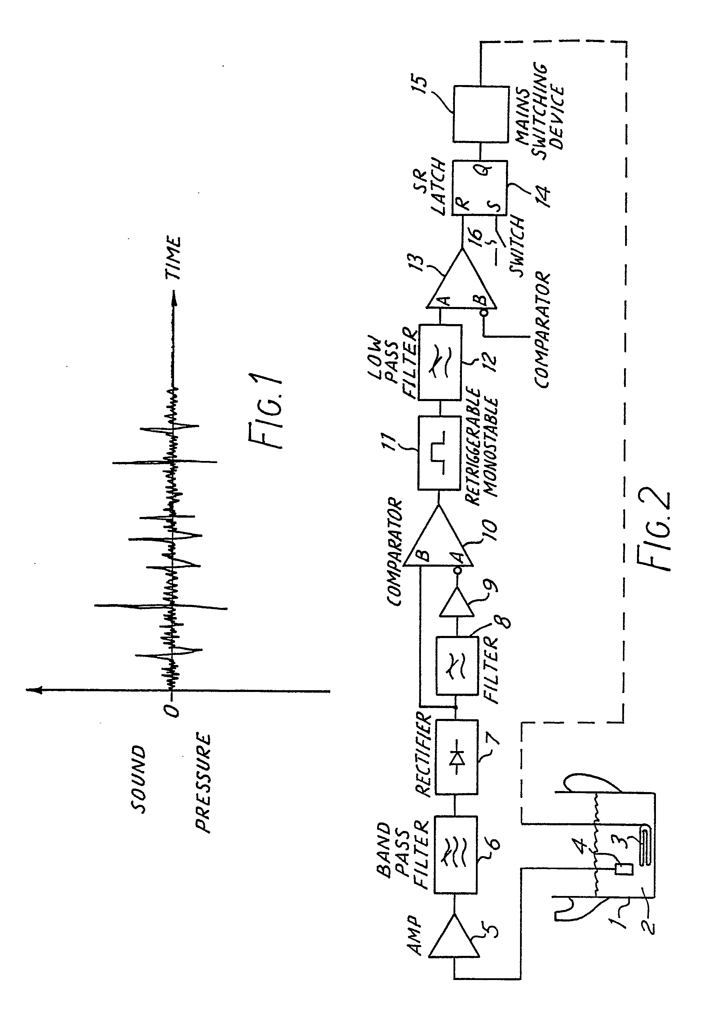

Figure 1 shows the functional block diagram of a device according to one embodiment of the invention. A signal is generated by a voltage controlled oscillator 1, frequency divider 2 and amplifier/filter 3 and passed through a power splitter 6. A carrier wave oscillator 4 provides a carrier wave which is modulated by the output signal from the amplifier/filter 3. The carrier wave of carrier frequency Fc is then propagated through a control delay line 5. The carrier wave 4 is also sent through a reference path with a phase adjustment means 7. The phase adjustment means 7 introduces a phase shift of a predetermined amount into the reference signal. The frequency modulated carrier wave is then demodulated in the delay path by a frequency discriminator 8 and in the reference path by a frequency discriminator 9. The output signals from the delay path and the reference path then pass into a phase comparator 10 at inputs A and B respectively. Any fluctuations in the time delay and hence phase shift introduced by the delay line 5 induced by, for example, temperature variations, will result in a phase difference between the phase shift of the delay signal and the fixed, frequency independent phase shift of the reference signal.

The phase comparator 10 compares the phase difference between the phase shifts of the delay and reference paths, signals A and B respectively, and generates up (U) and down (D) pulses to a loop filter 11. The output of the loop filter is a control voltage to the voltage controlled oscillator 1 which controls the oscillator frequency such that the signals at the input of the phase comparator 10 are maintained in phase.

Thus, any fluctuation in the time delay of the delay signal induced by for example temperature fluctuations are corrected so that the phase shift of the delay line 5 is maintained substantially equal to the predetermined phase shift of a reference signal. This is achieved by using effectively a phase locked loop to control the variable frequency oscillator to provide a temperature-varying frequency source.

A phase lock detector 12 can be connected to monitor the phase comparator U and D outputs. If the loop becomes unlocked, the U and D signals become unbalanced and the difference between them can be amplified and detected to indicate an out of lock condition.

The phase comparator 10 must have a response as follows so as to ensure locking always pulls the oscillator frequency in the direction to reduce the phase difference between the delayed and reference paths.

Taking phase difference S = Phase A - Phase B; if O < S<180 degrees:

A leads, frequency too high for delay time. D output integrated over 1 cycle must be higher than U output;

if 180<S < 360 degrees: A lags, frequency too high for delay time. U output integrated over 1 cycle must be higher than D output.

A suitable logic circuit for the phase comparator 10 is shown in Figure 3(a). Gates 13 and 14 generate an inverted A input, denoted A*, and a buffered A input, denoted A′. Gates 13 and 14 generate B* and B′ signals. Gates 17, 18, 19 and 20 are provided to generate short setting and resetting pulses for the R-S flip flops from the edges of the input signals. Gates 21 and 22 form one flip flop which has P and P* outputs, and gates 23 and 24 form another flip flop which has Q and Q* outputs.

The inputs of the flip flop 21, 22 are connected such that the leading edge of A sets P, and the trailing edge of B resets P (sets P*). The inputs of the flip flop 23, 24 are connected such that the leading edge of B sets Q, and the trailing edge of A resets Q (sets Q*). These signals are shown on the timing diagram of Figure 3(b) which also shows the effect of gate delays.

The result so far is that the mark-to-space ratio of P increases if B lags A, and the mark-to-space ratio of Q* increases if A lags B. The P and Q* outputs could be used to generate a phase difference signal, but there is a standing 50% approximately mark-to-space ratio at balance which generates a mean DC output of half the logic level. Hence any drift in logic level between P and Q* casues an error in the phase output. By gating P and Q to generate U=PQ, and P* and Q* to generate D=P*Q*, short pulses are generated. The minimum length of the pulses is determined by gate delays at zero phase shift and their presence at zero phase shift helps eliminate any dead band in the control response. The DC component of the U and D pulses is small compared to the component generated by a phase shift, therefore reducing sensitivity to logic level shifts.

Alternate U pulses follow the leading edges of A and B, transferred to the leading and trailing edge of the U pulse, then alternately the trailing edges of A and B, transferred to the leading and trailing edge of the U pulse.

Alternate D pulses follow the leading edges in a similar way to U, except that the B edges are transferred to the leading edge and the A edges are transferred to the trailing edge, see Figure 3(b).

At zero phase shift and equal input mark-to-space ratios, U and D pulses are equal to 1 gate delay wide. The difference in average voltage is then zero.

If B lags A, the trailing edges of both alternate U pulses are delayed, lengthening the pulses. The leading edges of the D pulses are delayed, and when the shift exceeds 1 gate delay the D pulses vanish. Conversely if A lags B, the D pulse widths are increased and the U pulse widths decrease then vanish. Thus the primary function of phase shift detection is performed.

If B occurs at lower frequency than A, the P and Q latches are set more often than they are reset, and the average value of the U output increases. If B occurs at higher frequency than A, the P and Q latches are reset more often than they are set, and the average value of the D output increases. This enables frequency comparison to occur when A and B are not the same frequency.

If the mark-to-space ratio of A increases, the leading edge of the first type of U pulse is advanced and the leading edge of the second type of U pulse is delayed. The alternate pulse widths shift in opposite directions and the average value remains the same. It is possible for one of the alternates to disappear, and pairs of unequal pulses or half frequency U pulses may be observed in practical circuits where mark-to-space ratios are not perfectly equal. Similarly, mark-to-space variations are cancelled on the D pulse outputs. When the alternate pulses are missing, mark-to-space ratio cancellation still occurs between the U and D signals. Similarly, mark-to-space variations of B are cancelled.

The number of gate delays from the inputs to the edges of P and Q* is 4. The number of gate delays from the inputs to the edges of P* and Q is 5 to the trailing edge and 3 to the leading edge. The imbalance in delay drift caused from the 5 delays to P* affects the D pulse width, but the 5 delays to Q affect the U pulse width in the same way, cancelling out the drift when U and D are differenced.

The phase detection range is limited by the amount of phase shift possible before the Pset and P*set zero levels collide, or the Qset and Q*set zero levels collide. If f is the frequency, and td is the gate delay, the maximum shift of B relative to A is:

Phase lead max. = (1/(2f) - 4td).360f

Phase lag max. = (1/(2f) - 2td).360f

The phase lead range is cut off when the input frequency satisfies 1/(2f) = 4td, which is 8.33 MHz for 74LS logic. At lower frequencies the phase range increases approaching +/- 180 degrees.

By choosing the appropriate logic family, a suitably high frequency phase comparator can be made; up to approximately 300 MHz for GaAs logic.

The dotted lines 25 of Figure 3(b) indicate the logic gates. which should be integrated on the same chip for thermal matching and show that the circuit can be split into four separate logic gate packages.

The division ratio of the frequency divider is chosen according to the expected frequency variation of the oscillator 1 over the design temperature range. The phase of the delayed modulation at A and B must remain within -180 to +180 degrees over the whole temperature range, otherwise the oscillator will mode jump. The controlling parameters are the control delay line delay temperature coefficient and the number of cycles of modulation frequency.

A device constructed as described above with reference to Figure 1 gives an error in the frequency tracking of the delay of a delay line of only ± 215 p.p.m. compared with a delay variation of ± 2735 p.p.m. over the temperature range 0 to 70° C. Thus the delay line temperature controlled oscillator 1 has reduced error due to temperature variations of the delay in the delay line by an order of magnitude.

A simplified version of the device of the invention is shown in Figure 2. In this embodiment the signal generated by the voltage controlled oscillator 1, frequency divider 2 and amplifier/filter 3 is propagated through the control delay in 5 and the reference path with phase adjustment means 7 and is not used to modulate a carrier wave as in the device shown in Figure 1. The two paths have a common power splitter 6 as in Figure 1. However, although the use of a modulated carrier wave in the delay line of Figure 1 is not strictly necessary, it is preferable, because the use of such a carrier wave more closely simulates the conditions of operation of a functional delay line.

In addition, to use a straightforward unmodulated signal with a delay line is prone to mode jumping where the delay is so long that the number of cycles of signal in the delay is large, for example 2400, and frequencies in the UHF band must be used because lower frequencies cannot be propagated in the delay line. Then the variation in oscillator frequency to obtain 180 degrees phase shift is so small that the phase loop can lock itself onto alternative modes e.g. 2399, 2400 or 2401 cycles of signal in the delay line 5. A shorter delay delay line would have few cycles of signal in it such that the range of variable control oscillator voltage would restrict the loop to locking on to one mode only. The use of a lower frequency modulation on a carrier enables fewer cycles of modulation frequency to be in the delay line, e.g. 256 whereby locking onto one unique mode of 256 cycles is achievable without unreasonably difficult tolerancing problems.

In an application of the device of the invention, the device, as shown in Figure 1 would be incorporated into a circuit with an operational delay line which would have variations in its timing compensated for by reference to a delay line temperature controlled oscillator device similar to that shown in Figure 1.

Figure 4 shows an example of the use of the invention to control a gate 26 at the output of the operational delay line 27. The delay line temperature controlled VCO 28 is constructed as shown in Figure 1. It provides an output at frequency $f_0$ directly from the variable controlled oscillator (1 in Figure 1) which is fed to a clock pulse generator 29. Arrival of an input signal at the functional delay line 27 provides an input synchronised pulse at the delay selector 30 which starts a counter 31 with timing logic. The gate 26 is opened when n pulses have been detected where:

$n = (t_f/t_c) (N\emptyset/2)$ and

$(t_f/t_c)$ = the ratio of the delay times of the functional delay line and the control delay line, the temperature and ageing characteristics being similar.

$N$ = the ratio of the oscillator frequency $f_0$ and the modulation frequency $f_0/N$.

$\emptyset$ = the phase shift produced by the phase adjustment means (7 in Figure 1).

The functional delay line 27 may provide a variable delay $t_f$. If so the delay selector 30 would be arranged to produce an appropriate adjustment in the timer so that the n pulses counted were commensurate with the required value of $(t_f/t_c)$.

## Claims

1. A device for compensating for variations in the delay times of an operational delay line comprising:

a control delay line to introduce a measurable phase shift into a signal passing along it;

a variable frequency oscillator to provide the control delay line with said signal;

a frequency independent reference signal having a pre-determined phase shift to act as a reference for the control delay line signal, and

means for controlling the frequency of the variable frequency oscillator so that the phase shift in the delay signal is maintained substantially constant and equal to the phase shift of the reference signal.

2. A device according to Claim 1, wherein the means for controlling the variable frequency oscillator comprises a phase locked loop.

3. A device according to Claim 2, wherein the means for controlling the variable frequency oscillator additionally comprises means for generating a carrier wave which is frequency modulated by the signal from the variable frequency oscillator in order to simulate the conditions of operation of a functional delay line.

4. A device substantially as hereinbefore described with reference to Figures 1, 3 and 4, or to Figures 2, 3 and 4 of the accompanying drawings.

EP 0 300 656 A2

*Fig.1*

*Fig.2*